# EUROPEAN PATENT APPLICATION

(11) **EP 4 492 439 A1**
(43) Date of publication of application: **15.01.2025**
(21) Application number: 23773446.2
(22) Date of filing: 30.01.2023
(51) Int. Cl.: H01L 21/67

(54) **SEMICONDUCTOR PROCESSING DEVICE AND SEMICONDUCTOR PROCESSING SYSTEM**

(30) Priority: 23.03.2022 CN 202210294831
(71) Applicant: Huaying Research Co., Ltd, Wuxi, Jiangsu 214000 (CN)
(72) Inventor: WEN, Sophia Ziying, Wuxi, Jiangsu 214000 (CN)
(74) Representative: Sun, Yiming
(86) International application number: PCT/CN2023/073750
(87) International publication number: WO 2023/179194

(57) **Abstract**

A semiconductor processing device comprises a lower chamber having a first supporting area configured to support the wafer, an upper chamber having a second supporting area and a temperature control component. When the upper chamber is engaged with the lower chamber, the wafer is placed between the first supporting area and the second supporting area. The temperature control component is disposed adjacent to the upper chamber and/or the lower chamber, configured to adjust the temperature of the upper chamber and/or the lower chamber by adjusting its own temperature. A first channel formed at an edge area of the first supporting area or the second supporting area. The first channel provides a first space for the flow of one or more chemical fluids for etching the edge area of the wafer. The temperature control component adjusts the temperature of the upper chamber and/or the lower chamber, thereby adjusting an etching width of the edge of the wafer. In this way, the etched width of the edge of the wafer can be fine-tuned.

## Description

### Field of the Invention

The present disclosure generally relates to a surface processing field of semiconductor wafer or similar workpiece, more particularly, to a semiconductor processing device and a semiconductor processing system.

### Background technology

Semiconductor wafers are subjected to a number of processing operations to meet the high standards in the semiconductor-related industries. In advanced applications of semiconductor wafers, it is desirable to have edges of semiconductor wafers that are uniform, smooth, damage-free, and polished, which brings challenges to a semiconductor wafer process resulting in its edge surface evenly and precisely etched.

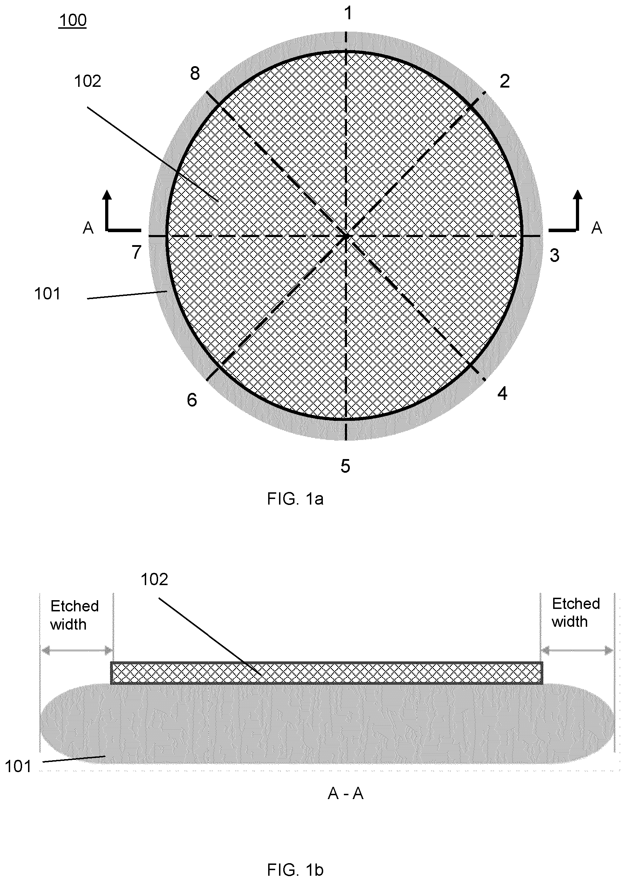

FIG.1a illustrates a top view of a schematic diagram of a semiconductor wafer 100. Semiconductor wafer 100 comprises a substrate layer 101 and a thin layer 102 deposited on substrate layer 101. FIG.1b illustrates a cross-section view of semiconductor wafer 100 along a direction of A-A. Measurement points 1-8 are positions measuring related data of the semiconductor wafer in the processing operations. The etched width refers to the difference between the radius of the substrate layer 101 and the thin layer 102, as illustrated in FIG. 1b. The etched width shall be substantially the same at each of the measurement points 1-8. The smaller the difference between the maximum and minimum etched widths, the higher the uniformity will be. For example, when the edged width is designed for 0.7mm, a difference between a maximum etched width and a minimum etched width shall not be more than 0.1mm, otherwise resulting in an un-even and/or a non-uniform etched width. The difference between the maximum etched width and the minimum etched width, if exceeding 0.1mm, will directly affect the quality of subsequent processing operations and eventually cause poor performance of integrated circuit chips, affecting chip manufacturing yield.

The semiconductor wafer wet processing process has the advantages of simple principle, flexible process and low cost. There are several conventional methods of etching the semiconductor wafer surface edge. For example, a method of polishing the edge of the semiconductor wafer has been adopted. It rotates the semiconductor wafer and uses physical friction and chemical gas-liquid combination to remove a thin layer from the substrate layer. The polishing method, however, is mainly used in the manufacturing process of semiconductor wafer with less accuracy requirement and is prone to damaging the retained thin layer as well as the substrate layer. The damaged edges may cause edge slip during thermal processing of the wafer and eventually cause the wafer discarded. A method of sucking the semiconductor wafer with a vacuum tip is also commonly adopted. It uses a vacuum tip to suck on the semiconductor wafer where the thin layer is designed to be retained, exposing the rest part of the thin layer outside the vacuum tip, and then immerses the vacuum tip and the semiconductor wafer entirely in a chemical etching solution to etch away the exposed thin layer. The vacuum tip method, however, causes the unsmooth removal of the thin layer and uneven etched widths. Similarly, a method of depositing a pre-trimmed thin layer onto the substrate layer of the wafer will cause the uneven etched widths, as the center of the pre-trimmed thin layer may not be aligned with the center of the substrate layer of the wafer. Another commonly used method is the filming method, which uses pure anticorrosive PTFE, PE and other plastic films to protect the parts of the film that need to be retained, and then exposes the whole to a chemically etching gas environment or soaks in a chemical etching solution to etch the exposed parts. The filming method is often because the center of the pre-cut film may not be aligned with the center of the wafer substrate, resulting in uneven etched width; and there are many process steps, which need to use a variety of equipment to complete, including filming, wet etching, cleaning and removal film and other equipment. Similarly, a new method of shower, which works by using a special nozzle to spray the fluid used for etching the edge of the rotating wafer to etching areas, for accurate, uniform, smooth and no damage etching. Although the shower method has higher etching effect, but its design of equipment and parts of the processing precision requirements are very high, the equipment and process cost is too high.

In addition, since most materials have a certain coefficient of temperature expansion, a semiconductor wafer edge processing device made of a material with high temperature expansion coefficient may result in different etched widths of the wafer edge because of the temperature changes during manufacture, operation, transportation, or other unknown factors.

Moreover, different processes and manufacturers often require different etched widths for the wafer edges, such as some etched widths of 0.5mm, some etched widths of 0.6mm, some etched widths of 0.3mm, etc. In order to meet the needs of different processes and manufacturers, semiconductor wafer edge processing devices with different etching sizes are manufactured separately, which is costly.

In view of this, it would be necessary to develop a new type of semiconductor wafer edge processing device that can solve the above issues.

### SUMMARY OF THE INVENTION

The present disclosure provides a new semiconductor edge processing device and system that can solve the existing problems in prior technics and achieve the adjustment of the etched width of the wafer edge.

To achieve the above objective, in one aspect, the present disclosure provides a semiconductor processing device comprising a lower chamber having a first supporting area configured to support the wafer, an upper chamber having a second supporting area, wherein when the upper chamber is engaged with the lower chamber, the wafer is placed between the first supporting area and the second supporting area, a temperature control component disposed adjacent to the upper chamber and/or the lower chamber, which adjusts the temperature of the upper chamber and/or the lower chamber by adjusting its own temperature. A first channel formed at an edge area of the first supporting area or the second supporting area. The first channel provides a first space for flow of one or more chemical fluids for etching the edge of the wafer. A temperature control component is configured to adjust a temperature of the upper chamber and/or the lower chamber to utilizing a heat-expansion and cold-contraction of the upper chamber and/or the lower chamber to fine tune the position of the edge of the first supporting area and/or the second supporting area, thereby adjusting a width of an edge of the wafer extending into the first space, and ultimately adjusting an etched width of the edge of the wafer.

In another aspect, the present disclosure provides a semiconductor processing system, comprising a semiconductor processing device; and a material storage device connected to the semiconductor processing device for storing and exchanging one or more chemical fluids in the semiconductor processing device.

Exemplary implementations of the present disclosure can be used for semiconductor wafer processing, uniformly and accurately etching the surface of the edges. Furthermore, it can lower the impact of temperature changes on the accuracy of etched width of the wafer edge.

Exemplary implementations of this disclosure can provide multiple advantages over existing solutions.

The present disclosure utilizes the temperature control component to adjust the temperature of the upper chamber and/or the lower chamber accordingly, thereby adjusting the small size changes of the upper and/or lower chamber, ultimately adjusting the etched width of the edge of the wafer.

These and other features, aspects, and advantages of the present disclosure will be apparent from a reading of the following detailed description together with the accompanying figures, which are briefly described below. The present disclosure comprises any combination of one or more features or elements set forth in this disclosure, regardless of whether such features or elements are expressly combined or otherwise recited in a specific example implementation described herein. This disclosure is intended to be read holistically such that any separable features or elements of the disclosure, in any of its aspects and exemplary implementations, should be viewed as combinable unless the context of the disclosure clearly dictates otherwise.

It will therefore be appreciated that this Summary is provided merely for purposes of summarizing some exemplary implementations so as to provide a basic understanding of some aspects of the disclosure. Accordingly, it will be appreciated that the above described exemplary implementations are merely examples and should not be construed to narrow the scope or spirit of the disclosure in any way. Other example implementations, aspects, and advantages will become apparent from the following detailed description taken in conjunction with the accompanying figures which illustrate, by way of example, the principles of some described exemplary implementations.

### BRIEF DESCRIPTION OF THE DRAWINGS

The present disclosure may be better understood by referring to the drawings as well as the detailed description below. In particular, same numerals are used to refer to same structural parts throughout the drawings, and wherein:
FIG. 1a illustrates a top view of a schematic diagram of a semiconductor wafer.
FIG. 1b illustrates a cross-section view of the semiconductor wafer along a direction A-A of FIG. 1a.
FIG. 2a illustrates a cross-section view of an exemplary device 200, according to exemplary implementations of the present disclosure.
FIG. 2b illustrates a detailed view of a circle A shown in FIG. 2a.
FIG. 2c illustrates a simplified detailed view of a circle B shown in FIG. 2b.
FIG. 2d illustrates a detailed view of a circle C shown in FIG. 2c.
FIG. 2e illustrates a bottom view of an upper chamber 220 of exemplary device 200.
FIG. 2f illustrates a top view of a lower chamber 210 of exemplary device 200.
FIG. 3a illustrates a cross-section view of an exemplary device 300, according to exemplary implementations of the present disclosure.
FIG. 3b illustrates a detailed view of a circle D shown in FIG. 3a.
FIG. 3c illustrates a detailed view of a circle D shown in FIG. 3a with a jut 342.
FIG. 3d illustrates a bottom view of an upper chamber 320 of exemplary device 300.
FIG. 3e illustrates a top view of a lower chamber 310 of exemplary device 300.
FIG. 4a illustrates a cross-section view of an exemplary device 400.
FIG. 4b illustrates a detailed view of a circle E shown in FIG. 4a.
FIG. 4c illustrates a detailed view of a circle F shown in FIG. 4b.
FIG. 4d illustrates a bottom view of an upper chamber 420 of exemplary device 400.
FIG. 4e illustrates a top view of a lower chamber 410 of exemplary device 400.
FIG. 5 illustrates an exemplary system 500 comprising a processing device and a material storage device.
FIG. 6 illustrates an exemplary method using an device to process an edge area of a semiconductor wafer.
FIG 7 illustrates an exemplary schematic diagram of the structure of a semiconductor processing device which can fine tune the etched width of the edge of a wafer.

### DETAILED DESCRIPTION OF THE PREFERRED EMBODIMENTS

Some implementations of the present disclosure will now be described more fully hereinafter with reference to the accompanying figures, in which some, but not all implementations of the disclosure are shown. Indeed, various implementations of the disclosure may be embodied in many different forms and should not be construed as limited to the implementations set forth herein; rather, these exemplary implementations are provided so that this disclosure will be thorough and complete, and will fully convey the scope of the disclosure to those skilled in the art. For example, unless otherwise indicated, reference to something as being a first, second or the like should not be construed to imply a particular order. Also, something may be described as being above something else (unless otherwise indicated) may instead be below, and vice versa; and similarly, something described as being to the left of something else may instead be to the right, and vice versa. Like reference numerals refer to like elements throughout.

FIGs. 1a through 1b illustrate a schematic diagram of a semiconductor wafer 100. FIG. 1a illustrates a top view of the schematic diagram of a semiconductor wafer 100. FIG. 1b illustrates a cross-section view of semiconductor wafer 100 along the direction A-A of FIG. 1a. As shown in FIGs. 1a-1b, semiconductor wafer 100 comprises a substrate layer 101 and a thin layer 102 deposited on the first side surface of substrate layer 101, and substrate layer 101 can be partially covered by thin layer 102. In another implementation, substrate layer 101 can be fully covered by thin layer 102. In another implementation, both sides of surface of substrate layer 101 can be respectively covered by a thin layer 102.

In some implementations, in processing operations of the semiconductor wafer, thin layer 102 shall be removed from substrate layer 101. For example, as shown in FIGs. 1a-1b, a radius of substrate layer 101 is smaller than a radius of thin layer 102, and an etched width refers to a difference between the two radii. Measurement points 1-8 are positions that measure related data of the semiconductor wafer, as illustrated in FIG. 1a. The etched width shall be substantially the same at each of the measurement points 1-8. The smaller the difference between the maximum and minimum etched widths, the higher the uniformity will be. For example, when the edged width is designed for 0.7mm, the difference between the maximum etched width and the minimum etched width shall not be more than 0.1mm. In some implementations, thin layers covering both sides of a surface of substrate layer 101 shall be partially or completely removed. The etched width for each side of the surface of substrate layer 101 can be the same or different.

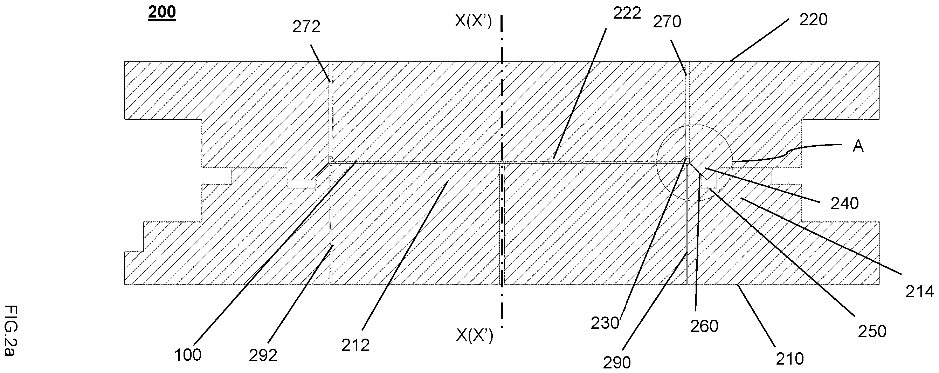

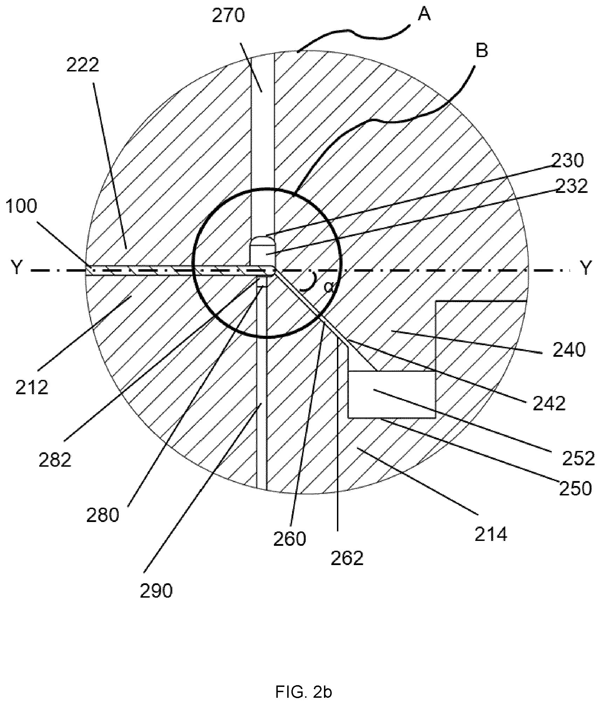

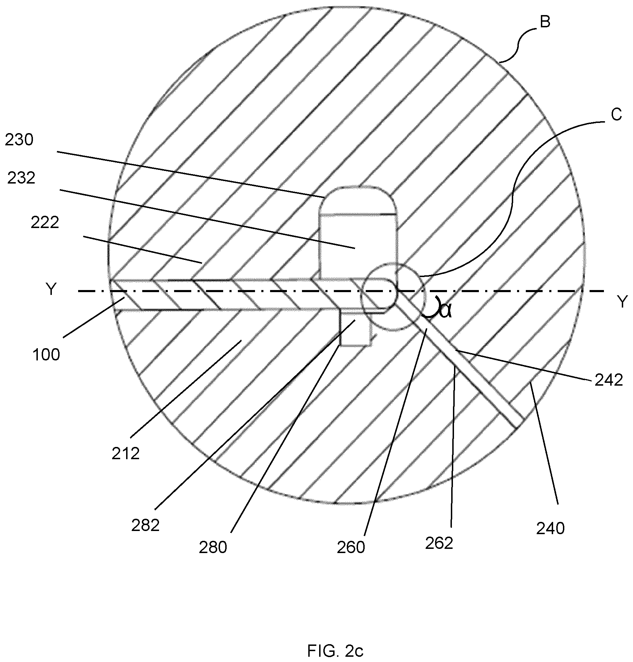

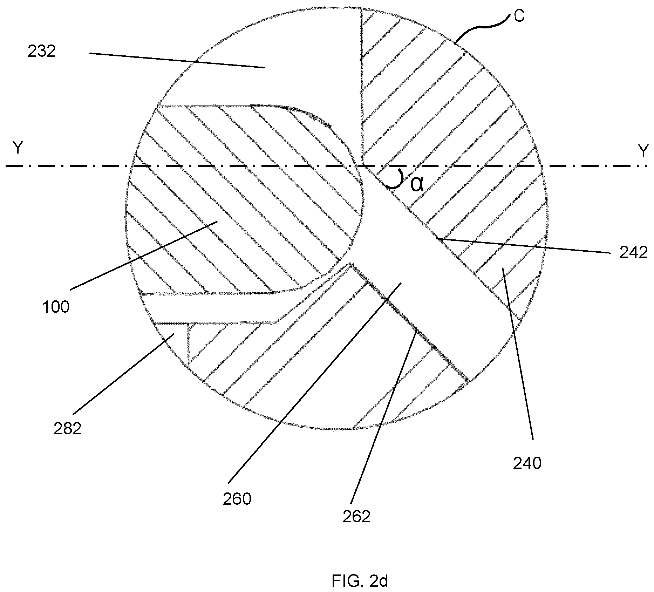

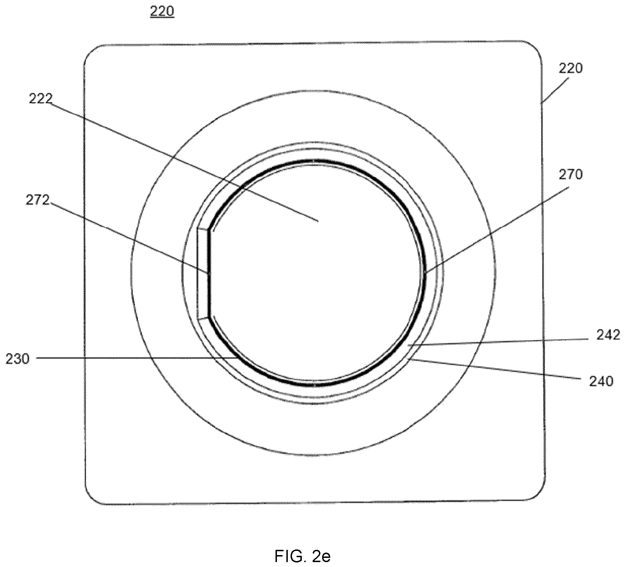

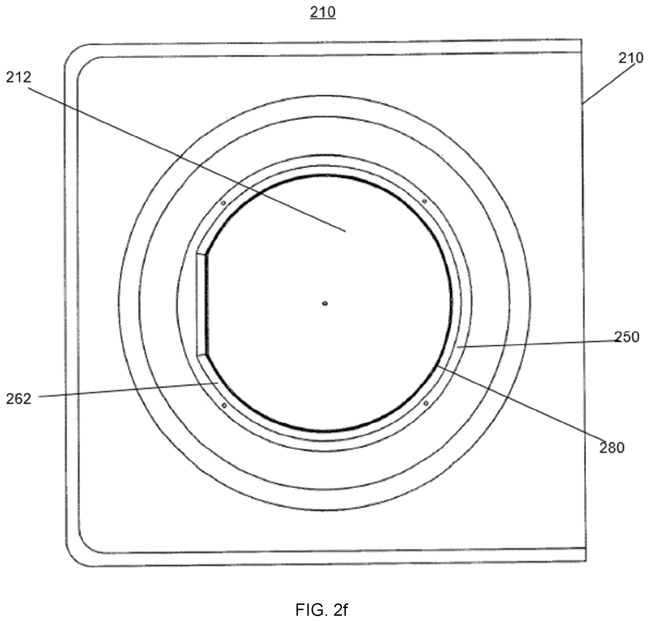

FIGs. 2a through 2f illustrate an exemplary device 200, according to exemplary implementations of the present disclosure. FIG. 2a illustrates a cross-section view of exemplary device 200. FIG. 2b illustrates a detailed view of a circle A shown in FIG. 2a. FIG. 2c illustrates a simplified detailed view of a circle B shown in FIG. 2b (omitting through holes). FIG. 2d illustrates a detailed view of a circle C shown in FIG. 2c. FIG. 2e illustrates a bottom view of an upper chamber 220 of exemplary device 200. FIG. 2f illustrates a top view of a lower chamber 210 of exemplary device 200.

In one exemplary implementation, device 200 comprises a lower chamber 210 having a first supporting area 212. First supporting area 212 may be configured to support a wafer 100 as described above with reference to FIGs. 1a through 1b. For example, as shown in FIG. 2a, first supporting area 212 may have an upper surface facing wafer 100. Wafer 100 may be placed on the upper surface of first supporting area 212. In some implementations, device 200 may comprise an upper chamber 220 having a second supporting area 222. For example, as shown FIG. 2a, second supporting area 222 may have a lower surface facing wafer 100. Upper chamber 220 may be engaged with lower chamber 210 to place wafer 100 between first supporting area 212 and second supporting area 222. For example, upper chamber 220 may move between two positions relative to lower chamber 210. In the first position, wafer 100 can be loaded to and/or unloaded from first supporting area 212. In the second position, upper chamber 220 and lower chamber 210 are engaged with each other so that wafer 100 may be fixed by the upper surface of first supporting area 212 and the lower surface of second supporting area 222 and may be accommodated for processing, as shown in FIG. 2a.

In some implementations or any combination of preceding exemplary implementations of device 200, as shown in FIGs. 2a through 2c, device 200 may comprise a first channel 230 formed at a peripheral area of first supporting area 212 or second supporting area 222. First channel 230 may be configured to provide a first space 232 for the flow of one or more chemical fluids for etching an edge area of wafer 100. For example, as shown in FIGs. 2a through 2c, first channel 230 may be formed at the peripheral area of second supporting area 222 in upper chamber 220. First channel 230 may be further formed on a lower surface of upper chamber 220, and an opening of first channel 230 may face wafer 100. In one implementation, first channel 230 may be configured to provide a first space 232, in which one or more chemical fluids may flow to etch the edge area of wafer 100. For example, as shown in FIGs. 2a through 2c, first space 232 may be formed by an internal surface of first channel 230 and wafer 100. In one implementation, first channel 230 may be annular and around the edge area of wafer 100. The entire edge area of wafer 100 may be accommodated into first space 232. In another implementation, first channel 230 may be arranged as an arc with a radian less than 360 degrees, and an edge area of wafer 100 may be selectively accommodated into first space 232. Then, the one or more chemical fluids may etch part of the edge area of the wafer in accordance with the arc of first channel 230.

In some implementations or any combination of preceding exemplary implementations of device 200, as shown in FIGs. 2a through 2c, upper chamber 220 may comprise a protrusion part 240 configured to press against an edge of wafer 100. For example, the protrusion part may directly contact an edge of wafer 100, and further press against the edge of wafer 100. In some implementations, as shown in FIG. 2a, a center axis X-X of wafer 100 may be perpendicular to an upper surface of wafer 100. A center axis X'-X' of second supporting area 222 may be perpendicular to a lower surface of second supporting area 222. A protrusion part 240 may be configured to align the center axis X-X of wafer 100 with the center axis X'-X' of second supporting area 222. For example, when upper chamber 220 is located in a first position, wafer 100 is loaded onto first supporting area 212. The center axis X-X of wafer 100 may not be aligned to the center axis X'-X' of a second supporting area 222. During the course that upper chamber 220 moves from a first position to a second position, protrusion part 240 may contact an edge of wafer 100, and then may press against an edge of wafer 100, pushing wafer 100 to move on an upper surface of first supporting area 212. When upper chamber 220 is located in the second position, the wafer may be fixed on the upper surface of first supporting area 212 and the center axis X-X of wafer 100 may be parallel to the center axis X'-X' of second supporting area 222. In another implementation, the center axis X-X of wafer 100 may overlap the center axis X'-X' of second supporting area 222.

In some implementations or any combination of preceding exemplary implementations of device 200, protrusion part 240 may be adjacent to second supporting area 222 and extend toward lower chamber 210. For example, as shown in FIGs. 2a and 2b, protrusion part 240 may be connected to second supporting area 222. Protrusion part 240 may extend toward lower chamber 210 where upper chamber 220 is located in a second position. In one implementation, protrusion part 240 may be formed next to first channel 230, as shown in FIGs. 2a and 2b. In some implementations, as shown in FIG. 2a, the center axis X-X of wafer 100 may be perpendicular to an upper surface of wafer 100 and the center axis X'-X' of second supporting area 222 may be perpendicular to a lower surface of upper chamber 220. The upper surface of wafer 100 may be parallel to the lower surface of the second supporting area. In one implementation, when the upper chamber is located in the second position, the upper surface of wafer 100 may overlap the lower surface of second supporting area 222 and the center axis X-X of wafer 100 may overlap the center axis X'-X' of second supporting area 222.

In some implementations or any combination of preceding exemplary implementations of the device 200, protrusion part 240 may comprise a closed loop arranged around wafer 100. For example, as shown in FIG. 2a, protrusion part 240 comprises a closed loop. The closed loop may be annular and around the entire edge area of wafer 100. Protrusion part 240 therefore may uniformly press against the edge area of wafer 100 for overlapping the center axis X-X of wafer 100 with the center axis X'-X' of second supporting area 222. In some implementations, the closed loop may comprise an arc with a radian less than 360 degrees, and the edge area of wafer 100 may be selectively resisted by protrusion part 240 for aligning and/or overlapping the center axis X-X of wafer 100 with the center axis X'-X' of second supporting area 222. In some implementation, protrusion part 240 may comprise an open loop.

In some implementations or any combination of preceding exemplary implementations of device 200, protrusion part 240 comprises an inner corner facing towards the center axis X'-X' of second supporting area 222. For example, as shown in FIG. 2c, protrusion part 240 may comprise an inner surface 242 inclining at an angle α to a first reference direction Y-Y. The first reference direction Y-Y may be parallel to a lower surface of second supporting area 222. The angle α may be within a range of 20°-90°. The inner corner may be formed by inner surface 242 and an inner surface of first channel 230 and may face towards the center axis X'-X' of second supporting area 222, as shown in FIGs. 2b and 2c. In one implementation, the inner corner may be configured to press against an edge area of wafer 100. For examples, as shown in FIG. 2b, during the course that upper chamber 220 moves from a first position to a second position, an inner corner of protrusion part 240 may contact an edge area of wafer 100, and then may press against an edge of wafer 100, pushing wafer 100 to move. When upper chamber 220 is located in the second position, the wafer may be fixed and the center axis X-X of wafer 100 may be parallel to the center axis X'-X' of second supporting area 222. In another implementation, the center axis X-X of wafer 100 may overlap the center axis X'-X' of second supporting area 222.

In some implementations or any combination of preceding exemplary implementations of device 200, a first groove 250 may be formed in a peripheral area 214 of lower chamber 210 and configured to provide a first groove space 252 for the flow of one or more chemical fluids. For example, as shown in FIGs. 2a, 2b and 2f, first groove 250 may be formed in peripheral area 214 of lower chamber 210, and positioned close to first supporting area 212 of lower chamber 210. First groove 250 may provide a first groove space 252 and the one or more materials can flow from first space 232 of first channel 230 to first groove space 252.

In some implementations or any combination of preceding exemplary implementations of device 200, a passage 260 may be formed between upper chamber 220 and lower chamber 210. For example, as shown in FIGs. 2b and 2f, lower chamber 210 may comprise a first upper surface 262 between first supporting area 212 and first groove 250. Passage 260 may be formed between first upper surface 262 of lower chamber 210 and inner surface 242 of protrusion part 240. Passage 260 may connect first space 232 with first groove space 252 for allowing the one or more chemical fluids to flow from first space 232 to first groove space 252 through passage 260. In one implementation, passage 260 may be blocked by protrusion part 240 from the flow of the one or more chemical fluids from first space 232 to first groove space 252. In another implementation, passage 260 may be blocked by first supporting area 210 from the flow of the one or more chemical fluids from first space 232 to first groove space 252.

In some implementations or any combination of preceding exemplary implementations of device 200, a first channel 230 may be formed at a peripheral area of second supporting area 222, as shown in FIGs, 2a through 2c. Upper chamber 220 may further comprise a first through hole 270 configured to allow the one or more chemical fluids to flow between a first space 232 and an outside of device 200. For example, first through hole 270 may pass through upper chamber 220 from an outside of device 200 to communicate with first space 232. In one implementation, the one or more chemical fluids may flow between first space 232 and an outside of device 200 through first through hole 270. In another implementation, upper chamber 220 may further comprise two or more first through holes (e.g., a secondary first through hole 272, as shown in FIGs. 2a and 2e) which may be substantially the same as the first through hole 270. In this implementation, at least one first through hole (e.g., first through hole 270) may be configured to serve as an inlet and the rest first through hole(s) (e.g., the secondary first through hole 272) may be configured to serve as an outlet. First space 232 may connect to an outside of device 200 through first through hole 270 and secondary first through hole 272. In this implementation, the one or more chemical fluids may flow into first space 232 of first channel 230 from the outside of device 200 through first through hole 270, and flow out of first space 232 to the outside of device 200 through secondary first through hole 272.

In some implementations or any combination of preceding exemplary implementations of device 200, a second channel 280 may be formed at a peripheral area of first supporting area 212 and configured to provide a second space 282 for the flow of one or more chemical fluids for etching an edge area of wafer 100. For example, as shown in FIGs. 2a through 2c, a second channel 280 may be formed at a peripheral area of first supporting area 212 in lower chamber 210. Second channel 280 may be further formed on an upper surface of lower chamber 210, and an opening of second channel 280 may face toward wafer 100, as shown in FIGs. 2a and 2f. In one implementation, second channel 280 may be configured to provide a second space 282, in which the one or more chemical fluids may flow to etch an edge area of wafer 100. For example, as shown in FIGs. 2a through 2c, a second space may be formed by an internal surface of second channel 280 and wafer 100. In one implementation, second channel 280 may be annular and around an edge area of wafer 100. The entire edge area of wafer 100 may be accommodated into second space 282. In another implementation, second channel 280 may be arranged as an arc with a radian less than 360 degrees, and the edge area of wafer 100 may be selectively accommodated into second space 282. Then, the one or more chemical fluids may etch a part of the edge area of the wafer in accordance with the arc of the second channel 280. In some implementations, second channel 280 may be arranged in a shape identical to first channel 230. In some implementations, second channel 280 may be arranged close to first upper surface 262 between first supporting area 212 and first groove 250. A passage 260 may be formed between first upper surface 262 of lower chamber 210. Passage 260 may connect second space 282 with first groove space 252 for allowing the one or more chemical fluids to flow from second space 282 to first groove space 252 through passage 260. In one implementation, passage 260 may be blocked by protrusion part 240 from the flow of the one or more chemical fluids from second space 282 to first groove space 252. In another implementation, passage 260 may be blocked by first supporting area 210 from the flow of the one or more chemical fluids from second space 282 to first groove space 252.

In some implementations or any combination of preceding exemplary implementations of device 200, lower chamber 210 may comprise a second through hole 290 configured to allow one or more chemical fluids to flow between a second space 282 and an outside of device 200. For example, as shown in FIGs. 2a and 2b, second through hole 290 may pass through lower chamber 210 from an outside of device 200 to communicate with second space 282 of second channel 280. In one implementation, the one or more chemical fluids may flow between second space 282 and the outside of device 200 through second through hole 290. In another implementation, the one or more chemical fluids may flow from the outside of device 200 to second space 282 of second channel 280 through second through hole 290, and then flow from second space 282 of second channel 280 to first groove space 252 of first groove 250 through passage 260. In some implementations, lower chamber 210 may further comprise one or more second through holes (e.g., a secondary second through hole 292, as shown in FIG. 2a) which may be substantially the same as second through hole 290. In this implementation, at least one second through hole (e.g., a second through hole 290) may be configured to serve as an inlet and the rest second through hole(s) (e.g., secondary second through hole(s) 292) may be configured to serve as an outlet. Second space 282 may connect to an outside of device 200 through second through hole 290 and secondary second through hole 292. In one implementation, the one or more materials may flow into second space 282 of second channel 280 from the outside of device 200 through second through hole 290, and flow out of second space 282 to the outside of device 200 through secondary second through hole 292. In another implementation, the one or more chemical fluids may flow into second space 282 of second channel 280 from the outside of device 200 through second through hole 290 and secondary second through hole 292, and then flow from second space 282 of second channel 280 to first groove space 252 of first groove 250 through passage 260.

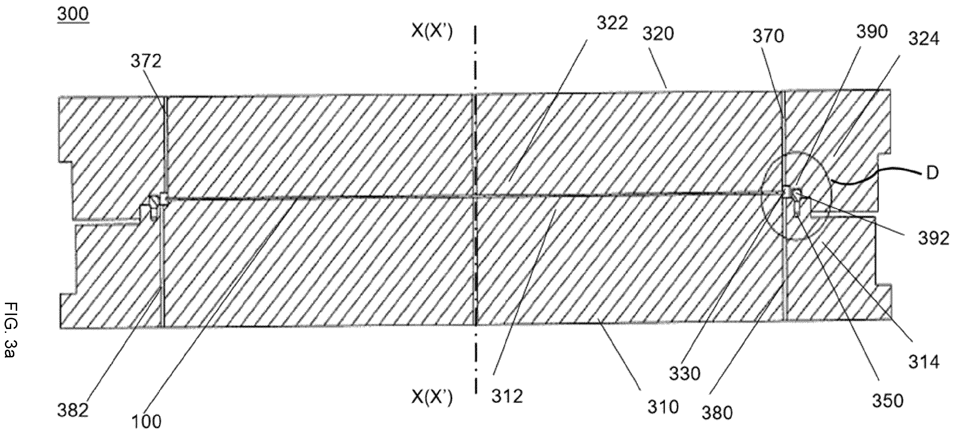

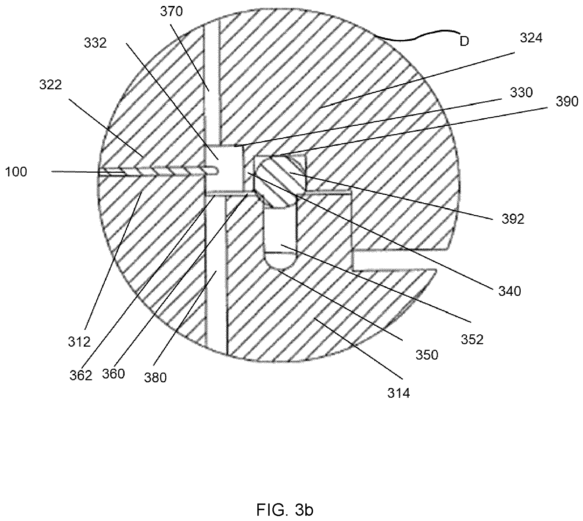

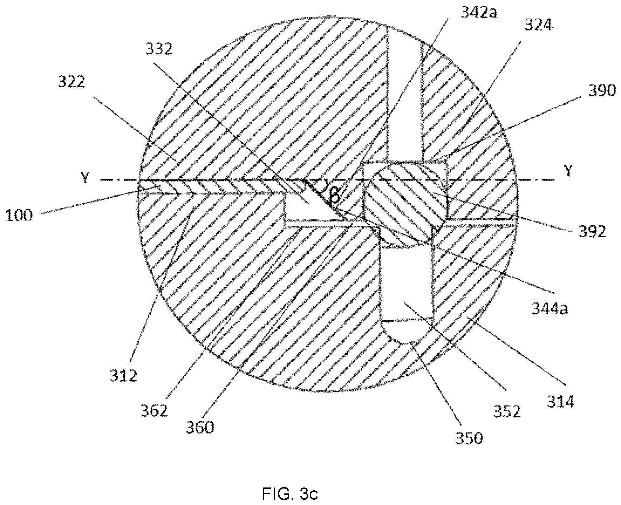

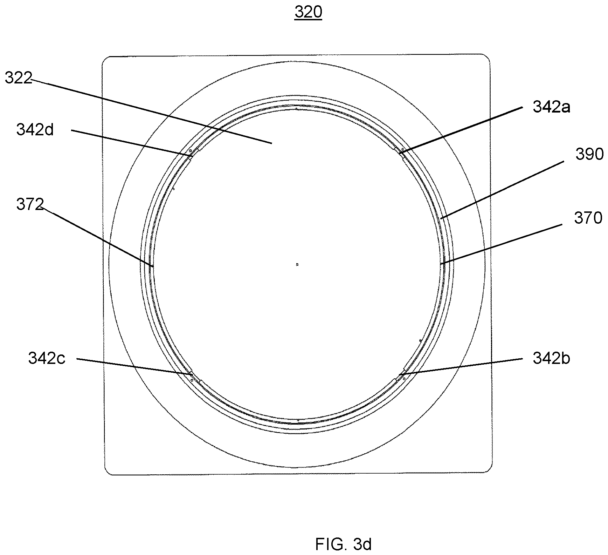

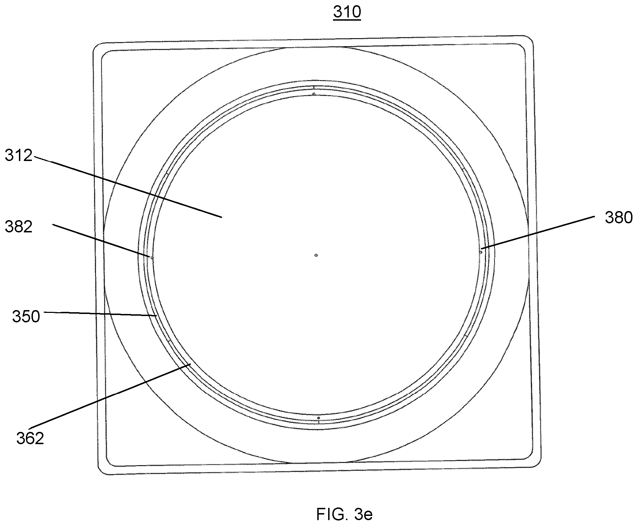

FIGs. 3a through 3e illustrate an exemplary device 300, according to exemplary implementations of the present disclosure. FIG. 3a illustrates a cross-section view of exemplary device 300. FIG. 3b is a detailed view of a circle D shown in FIG. 3a. FIG. 3c is a detailed view of the cross section of exemplary device 300 where a protrusion part is located. FIG. 3d is a bottom view of an upper chamber 320 of exemplary device 300. FIG. 3e is a top view of a lower chamber 320 of exemplary device 300.

In one exemplary implementation, as shown in FIGs. 3a through 3e, device 300 may comprise a lower chamber 310 having a first supporting area 312. Lower chamber 310 and first supporting area 312 may respectively be referred to a lower chamber 210 and a first supporting area 212 as described above with reference to FIGs. 2a through 2f. device 300 may comprise an upper chamber 320 having a second supporting area 322. Upper chamber 320 and second supporting area 322 may respectively be referred to an upper chamber 220 and a second supporting area 222 as described above with reference to FIGs. 2a through 2f. Upper chamber 320 may engaged with lower chamber 310 to place a wafer 100 between first supporting area 312 and second supporting area 322, as described above. device 300 may comprise a first channel 330 formed at a peripheral area of first supporting area 312 or second supporting area 322. First channel 330 may be referred to a first channel 230 as described above with reference to FIGs. 2a through 2f. For example, first channel 330 may be formed at the peripheral area of second supporting area 322 in upper chamber 320 and configured to provide a first space 332 for the flow of one or more chemical fluids for etching an edge area of wafer 100. First space 332 may be referred to a first space 232 as described above with reference to FIGs. 2a through 2f. In some implementations, first space 332 of first channel 330 may also be formed by an internal surface of first channel 330, lower chamber 310, and wafer 100. An entire or a partial edge area of wafer 100 may be accommodated into first space 332 of first channel 330, and the one or more chemical fluids can contact and etch the edge area of wafer 100.

In some implementations or any combination of preceding exemplary implementations of device 300, as shown in FIGs. 3a through 3d, upper chamber 320 may comprise a protrusion part 340 configured to press against an edge of wafer 100 and to align a center axis X-X of wafer 100 with a center axis X'-X' of a second supporting area 322. Protrusion part 340 may be referred to a protrusion part 240 as described above with reference to FIGs. 2a through 2e.In some implementations, protrusion part 340 may comprise a plurality of juts 342 being circularly and evenly arranged around wafer 100 to uniformly press against an edge area of wafer 100. Each of the plurality of juts 342 may extend from protrusion part 340 into a first space 332 of first channel 330. For example, as shown in FIGs. 3c and 3d, protrusion part 340 comprises four juts (e.g., juts 342a through 342 d). Each of the plurality of juts 342 may comprise an inner surface 344 inclining at an angle β to a reference direction Y-Y. A range of angle β may be within 20°-90°. The inner surface may face toward to an edge of wafer 100. The reference direction Y-Y may be parallel to an upper surface of wafer 100, or perpendicular to the center axis X'-X' of second supporting area 322. For example, as shown in FIG. 3c, jut 342a comprise an inner surface 344a, inclining at angle β to the reference direction Y-Y. Inner surface 344a may be arranged to press against an edge of wafer 100 and push wafer 100 to move for aligning the center axis X-X of wafer 100 with the center axis X'-X' of second supporting area 322. Protrusion 340 may comprise a plurality of juts 342. In some implementations, protrusion 340 may comprise six juts 342. In some implementations, protrusion 340 may comprise eights juts 342. In some implementations, protrusion 340 may comprise twelve juts 342.

In some implementations or any combination of preceding exemplary implementations of device 300, as shown in FIGs. 3a through 3c, a first groove 350 may be formed at a peripheral area 314 of lower chamber 310 and configured to provide a first groove space 352 for the flow of one or more chemical fluids. First groove 350, peripheral area 314 of lower chamber 310, and first groove space 352 of first groove 350 may respectively be referred to a first groove 250, a peripheral area 214 of a lower chamber 220, and a first groove space 252 of a first groove 250, respectively, as described above with reference to FIGs. 2a through 2f. In some implementations, a passage 360 may be formed between upper chamber 320 and lower chamber 310, connecting first space 332 with first groove space 352 for allowing the one or more chemical fluids to flow from first space 332 to first groove space 352 through a passage 360. Passage 360 may be referred to a passage 260 as describe above with reference to FIGs. 2a through 2f. In some implementations, passage 360 may be formed between protrusion part 340 and a first upper surface 362 of lower chamber 310. First upper surface 362 may be adjacent to first supporting area 312 and positioned between first supporting area 312 and first groove 350, as shown in FIGs. 3a through 3c and 3e.

In some implementations or any combination of preceding exemplary implementations of device 300, upper chamber 320 may further comprise a first through hole 370 configured to allow one or more chemical fluids to flow between first space 332 and an outside of device 300, as shown in FIGs. 3a, 3b, and 3d. First through hole 370 may be referred to a first through hole 270 as described above with reference to FIGs. 2a through 2e. In some implementations, upper chamber 320 may further comprise one or more first through holes (e.g., a secondary first through hole 372, as shown in FIGs. 3a and 3d), which may be substantially the same as first through hole 370. An arrangement of the one or more first through holes may be referred to an arrangement of the one or more first through holes as described above with reference to FIGs. 2a and 2e.

In some implementations or any combination of preceding exemplary implementations of device 300, as shown in FIGs. 3a, 3b, and 3e, lower chamber 310 may comprise a second through hole 380 configured to allow one or more chemical fluids to flow between a first space 332 and an outside of device 300, as shown in FIGs. 3a and 3b. Second through hole 380 may pass through lower chamber 310 from an outside of device 300 to communicate with a first space 332 of first channel 330. In some implementations, the one or more chemical fluids may flow from an outside of device 300 to first space 332 through a second through hole 380 and then flow from first space 332 to a first groove space 352 of first groove 350 through a passage 360. In some implementations, the one or more chemical fluids may flow from an outside of device 300 to first space 332 of first channel 330 through a first through hole 370, and then flow from first space 332 to first groove space 352 through passage 360 and to the outside of device 300 through second through hole 380.

In some implementations or any combination of preceding exemplary implementations of device 300, a second groove 390 may be formed at a peripheral area 324 of upper chamber 320 and positioned above first groove 350. For example, as shown in FIGs. 3a through 3d, second groove 390 may be formed at a peripheral area 324 of upper chamber 320, and be close to a protrusion part 340. Second groove 390 may provide a second groove space to contain an object. An opening of second groove 390 may face to lower chamber 310. Second groove 390 may be positioned above first groove 350 such that first groove space 352 of first groove 350 may communicate with a second groove space of second groove 390. Second groove 390 may be arranged in the same way as first groove 350. For one example, first groove 350 and second groove 390 may be annual, as shown in FIGs. 3d and 3e. For another example, first groove 350 and second groove 390 may respectively be arranged as an arc with a radian less than 360 degrees.

In some implementations or any combination of preceding exemplary implementations of device 300, an elastic component 392 may be placed between first groove 350 and second groove 390, as shown in FIGs. 3a through 3c. In some implementations, elastic component 392 may be placed in first groove space 352 or in the second groove space. In some implementations, elastic component 392 may be placed in first groove space 352 and the second groove space. In some implementations, elastic component 392 may be configured to block the one or more chemical fluids from flowing from first space 332 to first groove space 352. For example, a width of elastic component 392 may be wider than a width of first groove 350 and a width of second groove 390, as shown in FIGs. 3a through 3c. An inner surface of first groove 350 and/or an inner surface of second groove 390 may press against elastic component 392. The one or more chemical fluids there may be blocked from flowing from first space 332 to first groove space 352.

In some implementations or any combination of preceding exemplary implementations of device 300, elastic component 392 may be an O-ring.

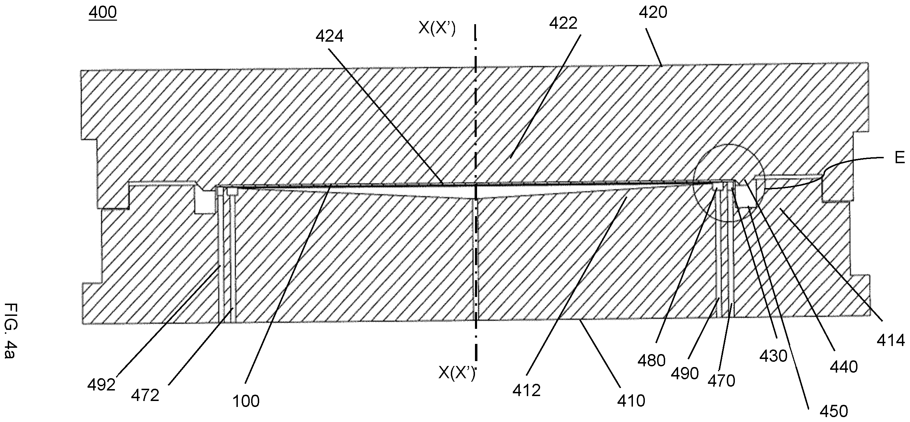

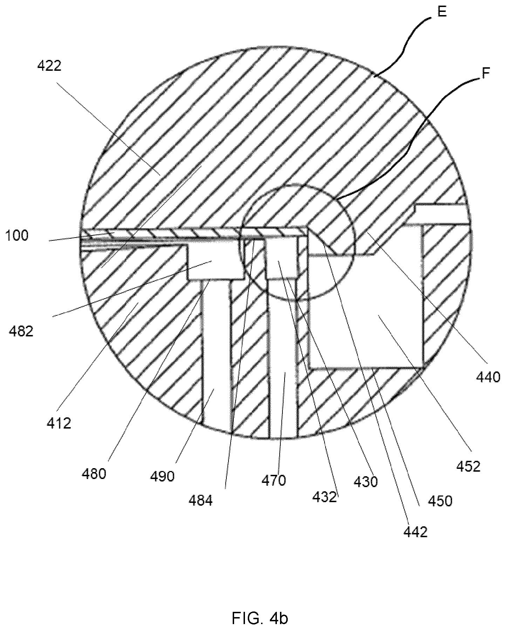

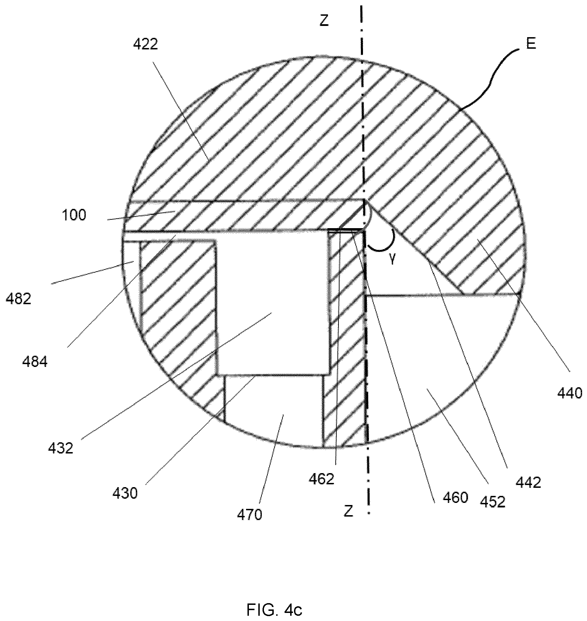

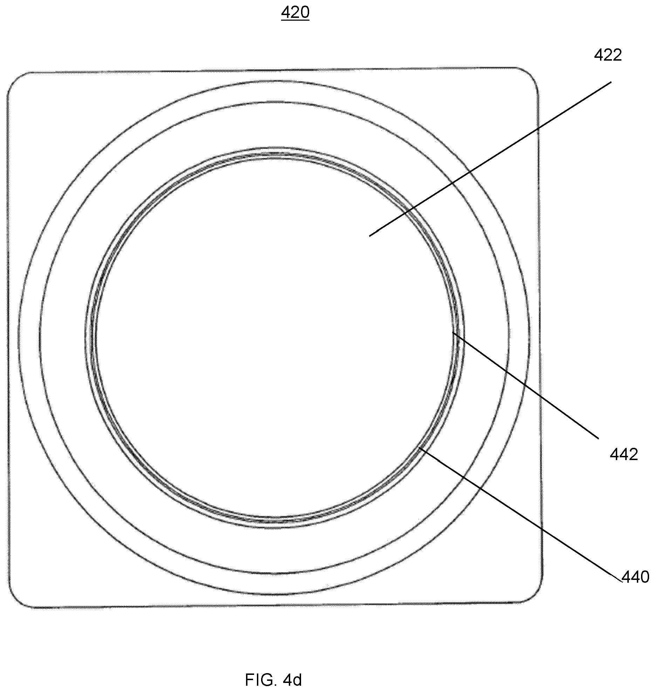

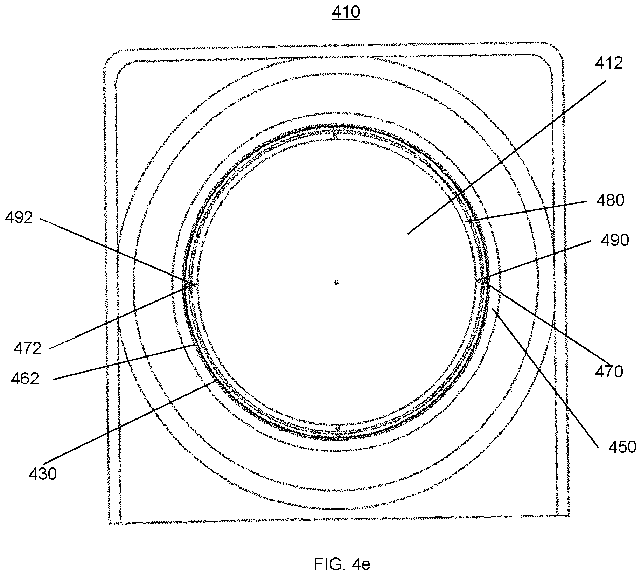

FIGs. 4a through 4e illustrate an exemplary device 400, according to exemplary implementations of the present disclosure. FIG. 4a illustrates a cross-section view of exemplary device 400. FIG. 4b illustrates a detailed view of a circle E shown in FIG. 4a. FIG. 4c illustrates a detailed view of a circle F shown in FIG. 4b. FIG. 4d illustrates a bottom view of an upper chamber 420 of exemplary device 400. FIG. 4e illustrates a top view of a lower chamber 410 of exemplary device 400.

In one exemplary implementation, as shown in FIGs. 4a-4e, device 400 may comprise a lower chamber 410 having a first supporting area 412. Lower chamber 410 and first supporting area 412 may respectively be referred to a lower chamber 210 and a first supporting area 212 as described above reference to FIGs. 2a through 2f. device 400 may comprise an upper chamber 420 having a second supporting area 422. Upper chamber 420 and second supporting area 422 may respectively be referred to an upper chamber 220 and a second supporting area 222 as described above with reference to FIGs. 2a through 2f. device 400 may comprise a first channel 430 formed at a peripheral area of first supporting area 412. First channel 430 may be referred to a first channel 230 as described above with reference to FIGs. 2a through 2f. For example, as shown in FIGs. 4a through 4c and 4e, first channel 430 may be formed at a peripheral area of first supporting area 412 in lower chamber 420 and configured to provide a first space 432 for the flow of one or more chemical fluids for etching an edge area of wafer 100. First space 432 of first channel 430 may also be formed by an internal surface of first channel 430 and wafer 100. An entire or a partial edge area of wafer 100 may be accommodated into first space 432 of first channel 430, and the one or more chemical fluids can contact and etch an edge area of wafer 100.

In some implementations or any combination of preceding exemplary implementations of device 400, as shown in FIGs. 4a through 4d, upper chamber 420 may comprise a protrusion part 440 configured to press against an edge of wafer 100 and to align a center axis X-X of wafer 100 with a center axis X'-X' of second supporting area 422. Protrusion part 440 may be referred to a protrusion part 240 as described above with reference to FIGs. 2a through 2e. In some implementations, protrusion part 440 may be positioned adjacent to a lower surface 424 of second supporting area 422, facing toward lower chamber 410. In some implementations, protrusion part 440 may comprise a plurality of juts being circularly and evenly arranged around wafer 100 to uniformly press against an edge area of wafer 100. The juts may be referred to juts 342 as described above with reference to FIGs. 3a through 3d.

In some implementations or any combination of preceding exemplary implementations of device 400, protrusion part 440 may comprise an inner surface 442 inclining at an angle to the center axis X'-X' of second supporting area 422, and inner surface 442 may be configured to press against an edge area of wafer 100. For example, as shown in FIG. 4a through 4d, the inner surface 442 may face toward wafer 100 and contact an edge of wafer 100. The inner surface 442 may be inclined at angle γ to a reference axis Z-Z. A range of angle γ may be within 20°-90°. The reference axis Z-Z may be parallel to the center axis X'-X' of second supporting area 422. In some implementations, inner surface 442 of protrusion part 440 may contact an edge of wafer 100. In some implementation, inner surface 442 of protrusion part 440 may be arranged to press against an edge of wafer 100, and therefore may align the center axis X-X of wafer 100 with the center axis X'-X' of second supporting area 422. In some implementation, inner surface 442 of protrusion part 440 may push wafer 100 to move and arrange the center axis X-X of wafer 100 to overlap the center axis X'-X' of second supporting area 422.

In some implementations or any combination of preceding exemplary implementations of device 400, as shown in FIGs. 4a, through 4c and 4e, a first groove 450 may be formed at a peripheral area 414 of lower chamber 410 and configured to provide a first groove space 452 for the flow of one or more chemical fluids. First groove 450, peripheral area 414 of lower chamber 410, and first groove space 452 of first groove 450 may respectively be referred to a first groove 250, a peripheral area 214 of lower chamber 220, and a first groove space 252 as described above with reference to FIGs. 2a-2f. In some implementations, a passage 460 may be formed between upper chamber 420 and lower chamber 410, connecting first space 432 with first groove space 452 for allowing the one or more chemical fluids flow from first space 432 to first groove space 452 through passage 460. Passage 460 may be referred to a passage 260 as describe above with reference to FIGs. 2a-2d. In some implementations, passage 460 may be formed between wafer 100 and a first upper surface 462 of lower chamber 410, as shown in FIG. 4c. First upper surface 462 may be located between first channel 430 and first groove 450, as shown in FIGs. 4c and 4e.

In some implementations or any combination of preceding exemplary implementations of device 400, as shown in FIGs. 4a through 4c and 4e, lower chamber 420 may further comprise a first through hole 470 configured to allow the one or more chemical fluids to flow between first space 432 and an outside of device 400. First through hole 470 may be referred to a first through hole 270 as described above with reference to FIGs. 2a-2e. In some implementations, lower chamber 420 may further comprise one or more first through holes (e.g., a secondary first through hole 472, as shown in FIGs. 4a and 4e) which may be substantially the same as first through hole 470. An arrangement of the one or more first through holes may be referred to an arrangement of the one or more first through holes as described above with reference to FIGs. 2a and 2d.

In some implementations or any combination of preceding exemplary implementations of device 400, as shown in FIGs. 4a, 4b, and 4e, a second channel 480 may be formed at a peripheral area of first supporting area 412 and configured to provide a second space 482 for the flow of the one or more chemical fluids for etching an edge area of wafer 100. Second channel 480 may be referred to a second channel 280 as described above with reference to FIGs. 2b, 2c, and 2f. In some implementations, first channel 430 and second channel 480 may be connected by a passway 484 for allowing the one or more chemical fluids flow between first space 432 of first channel 430 and second space 482 of second channel 480 through passway 484. For example, as shown in FIGs. 4b and 4c, passway 484 may be formed by wafer 100 and first supporting area 412 of lower chamber 410, connecting first channel 430, and second channel 480. The one or more chemical fluids may flow between first space 432 and second space 482 through a passway 484. In some implementations, the one or more chemical fluids may flow from second space 482 to first groove space 452 by going through passway 484, first space 432, and passage 460.

In some implementations or any combination of preceding exemplary implementations of device 400, as shown in FIGs. 4a, 4b and 4e, lower chamber 410 may comprise a second through hole 490 configured to allow the one or more chemical fluids to flow between second space 482 and an outside of device 400. Second through hole 490 may be referred to a second through hole 290 as described above with reference to FIGs. 2a-2c. In some implementations, lower chamber 410 may further comprise one or more second through holes (e.g., a secondary second through hole 492, as shown in FIGs. 4a and 4e) which may be substantially the same as second through hole 490. An arrangement of the one or more second through holes may be referred to an arrangement of the one or more second through holes as described above with reference to FIG. 2a.

This disclosure can enhance the precision and uniformity of the etching of wafer edge by using the protrusion part, and can obtain a flat surface for the wafer substrate layer by scientifically selecting the composition, the flow rate the etching chemical materials and contact time with the wafer edge, which is convenient for subsequent wafer processing operations. At the same time, it can save the cost of processing operations. It can selectively process the surface of the wafer edge, especially the precise control of edge etching area of the wafer.

In the above implementations, the protrusion part on the upper chamber were used as an example for explanation. In other implementations, the protrusion part may be located on the lower chamber. Of course, in some implementations, other positioning structures can be configured to press against an outer end of the edge of the wafer and to align a center axis of the wafer with a center axis of the second supporting area.

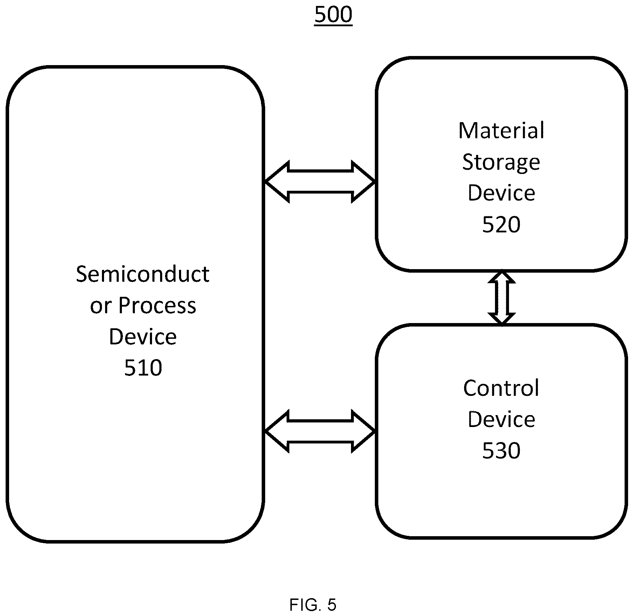

FIG. 5 illustrates an exemplary system 500 comprising a processing device 510 and a material storage device 520, according to exemplary implementations of the present disclosure. Processing device 510 may be referred to one of device 200, device 300, and device 400 as described above with reference to FIGs. 2a-2f, 3a-3e, and 4a-4e. For example, processing device 510 may comprise a lower chamber having a first supporting area configured to support a wafer; an upper chamber having a second supporting area, and the upper chamber being engaged with the lower chamber to place the wafer between the first supporting area and the second supporting area; and a first channel formed at a peripheral area of the first supporting area or the second supporting area, the first channel being configured to provide a first space for the flow of one or more chemical fluids for etching an edge area of the wafer. In some implementations, the upper chamber comprises a protrusion part being configured to press against an outer end of the edge of the wafer and to align a center axis of the wafer with a center axis of the second supporting area. Material storage device 520 may be connected to processing device 510. Material storage device may be configured to store the one or more chemical fluids and transfer the one or more chemical fluids between processing device 510 and material storage device 520. In some implementations, the one or more chemical fluids may be selected from H3PO4, HF, HCl, HNO3, H2O2, or any combination thereof.

In some implementations or any combination of preceding exemplary implementations of system 500, the protrusion part may be adjacent to the second supporting area and extend toward the lower chamber. The center axis of the wafer may be perpendicular to an upper surface of the wafer, the center axis of the second supporting area being perpendicular to a lower surface of the upper chamber, and the upper surface of the wafer being parallel to the lower surface of the second supporting area. In some implementations, the protrusion part may comprise a closed loop arranged around the wafer, and the protrusion part is configured to uniformly press against an edge area of the wafer for overlapping a center axis of the protrusion part with the center axis of the second supporting area.

In some implementations or any combination of preceding exemplary implementations of system 500, the protrusion part may be adjacent to the second supporting area and extend toward the lower chamber. The center axis of the wafer may be perpendicular to an upper surface of the wafer, the center axis of the second supporting area being perpendicular to a lower surface of the upper chamber, and the upper surface of the wafer being parallel to the lower surface of the second supporting area. In some implementations, the protrusion part may comprise a plurality of juts being circularly and evenly arranged around the wafer to uniformly press against the outer end of the edge of the wafer.

In some implementations or any combination of preceding exemplary implementations of system 500, a first groove may be formed at a peripheral area of the lower chamber and configured to provide a first groove space for the flow of one or more chemical fluids. In some implementations, a passage may be formed between the upper chamber and the lower chamber, connecting the first space with the first groove space for allowing the one or more chemical fluids to flow from the first space to the first groove space through the passage. In some implementations, a second groove may be formed at a peripheral area of the upper chamber and positioned above the first groove. In some implementations, an elastic component may be placed between the first groove and the second groove for blocking the one or more chemical fluids from flowing from the first space to the first groove space.

In some implementations or any combination of preceding exemplary implementations of system 500, system 500 may comprise a control device 530. Control device 530 may communicate and control processing device 510 and material storage device 520. For example, control device 530 can control a move of the upper chamber between a first position of loading/unloading the wafer and a second position of engaging the upper chamber and the lower chamber to process the wafer, the speed of the flow of the one or more chemical fluids, and the direction of the flow of the one or more chemical fluids. Control device 530 can detect the speed of the flow of the one or more chemical fluids, the direction of the flow of the one or more chemical fluids, the condition of the one or more chemical fluids, and the mal-function of processing device 510. In some implementations, control device may comprise a PLC, a controller, a sensor, a storage device (e.g., memory, hard drive, SSD, etc.).

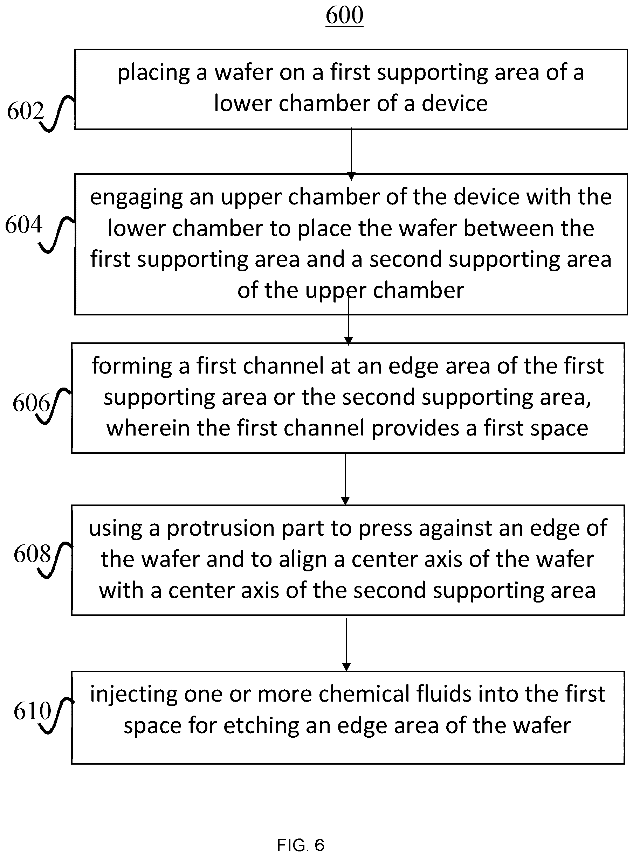

FIG. 6 illustrates an exemplary method 600 using an device to process an edge area of a semiconductor wafer 100, according to exemplary implementations of the present disclosure. The method may utilize the device which may be referred to one of device 200, device 300, device 400, or device 500, as described above with reference to FIGs. 2a-2f, 3a-3e, 4a-4e, and 5.

In an exemplary implementation, as shown in Fig. 6, at step 602, an device 200 (or device 300, device 400, or device 500) receives and places a wafer on a first supporting area of a lower chamber of the device. At step 604, the device engages its upper chamber with its lower chamber to place the wafer between the first supporting area and a second supporting area of the upper chamber. At step 606, a first channel is formed at an edge area of the first supporting area or the second supporting area, where in the first channel provides a first space. At step 608, the device uses a protrusion part to press against an outer end of the edge of the wafer and to align a center axis of the wafer with a center axis of the second supporting area. At step 610, the device injects one or more chemical fluids into the first space for etching an edge area of the wafer.

In some implementations or any combination of preceding exemplary implementations of method 600, at step 602, a wafer may be conveyed by a wafer conveying device to device 200 (or device 300, device 400, or device 500). The wafer may further be placed by the wafer conveying device onto a first supporting area of a lower chamber of device 200 (or device 300, device 400, or device 500). The first supporting area may have an upper surface facing the wafer. The wafer may be placed on the upper surface of the first supporting area. The wafer conveying device may place the wafer onto the first supporting area in a way that part of a lower surface of the wafer is covered by an upper surface of the first supporting area. In some implementations, the upper chamber of device 200 (or device 300, device 400, or device 500) may be in a first position, where the wafer can be loaded to and/or unloaded from the first supporting area. For example, the wafer can be conveyed from the wafer conveying device to the upper surface of the first supporting area.

In some implementations or any combination of preceding exemplary implementations of method 600, at step 604, device 200 (or device 300, device 400, or device 500) may engage an upper chamber with its lower chamber to place a wafer between a first supporting area and a second supporting area of the upper chamber. The upper chamber is in a second position where the lower chamber may be engaged with the upper chamber and the wafer may be fixed between the lower chamber and the upper chamber for allowing a process of an edge area of the wafer. The upper chamber may comprise a second supporting area, which may have a lower surface facing the wafer. The upper chamber may be engaged with the lower chamber to place the wafer between the first supporting area and the second supporting area. For example, the wafer may be fixed between the lower surface of the second supporting area and the upper surface of the first supporting area.

In some implementations or any combination of preceding exemplary implementations of method 600, at step 606, a first channel may be formed at an edge area of a first supporting area. The first channel may be further formed on a lower surface of the upper chamber, and an opening of the first channel may face the wafer. In some implementations, the first channel provides a first space for allowing a process of an edge area of a wafer. For example, one or more chemical fluids may flow in the first channel and etch an edge area of wafer. In some implementations, the first channel may be arranged as a closed loop. In some implementations, the first channel may be arranged as a circle. device 200 (or device 300, device 400, or device 500) or the wafer conveying device may place the wafer in a way that an entire or a partial edge area of the wafer is accommodated into the first space for processing. In some implementations, the first channel may be arranged as an arc with a radian less than 360 degrees. device 200 (or device 300, device 400, or device 500) or the wafer conveying device may place the wafer in a way that a partial edge area of the wafer is accommodated into the first space for processing.

In some implementations or any combination of preceding exemplary implementations of method 600, at step 608, a protrusion part is formed on an upper chamber or a lower chamber of device 200 (or device 300, device 400, or device 500). The device may use the protrusion part to press against an edge of a wafer. For example, the protrusion part may contact the edge of the wafer during a course that the upper chamber moves from a first position to a second position. Then the protrusion part may press against the edge of the wafer and push the wafer to move on an upper surface of a first supporting area of the lower chamber. When the upper chamber is engaged with the lower chamber, the wafer may be fixed on the upper surface of the first supporting area, and a center axis X-X of the wafer may be aligned with a center axis X'-X' of a second supporting area. A distance between the center axis X-X of the wafer and the center axis X'-X' of the second supporting area may be within a range of 0 mm - 0.1mm. In some implementations, the protrusion part may be adjacent to the second supporting area and extend toward the lower chamber. In one implementation, the protrusion part may be formed next to the first channel.

In some implementations, the protrusion part comprises an inner corner facing towards the center axis X'-X' of the second supporting area. The inner corner may be formed by an inner surface of the protrusion part and an inner surface of the first channel and may face towards the center axis X'-X' of the second supporting area. In one implementation, the inner corner may be configured to press against an edge area of the wafer. For example, during the course that the upper chamber moves from a first position to a second position, the inner corner of the protrusion part may contact an edge of the wafer, and then may press against the edge of the wafer, pushing the wafer to move. In some implementations, the inner surface of the protrusion part may contact an edge of the wafer, and then may press against the edge of the wafer, pushing the wafer to move.

In some implementations or any combination of preceding exemplary implementations of method 600, at step 610, device 200 (or device 300, device 400, or device 500) may inject one or more chemical fluids into a first space for etching an edge area of a wafer. The one or more chemical fluids may flow around an edge of the wafer in a first space and etch the edge area of the wafer accommodated into the first space. In some implementations, the device may comprise a through hole connecting the first space with an outside of the device. The one or more chemical fluids may be injected into the first space through the through hole. In some implementations, the one or more chemical fluids may flow from the first space into the outside of the device through the through hole. In some implementations, the device may comprise two through holes, each of which may respectively connect the first space with the outside of the device. The two through holes may be arranged with a distance away to each other. The one or more chemical fluids may be injected into the first space through one through hole and flow from the first space into the outside of the device through the other through hole.

As mentioned in the background, since most materials have a certain coefficient of temperature expansion, a semiconductor wafer edge processing device made of a material with high temperature expansion coefficient may result in different etched widths of the wafer edge because of the temperature changes during manufacture, operation, transportation, or other unknown factors. Moreover, different processes and manufacturers often require different etched widths for the edges of the wafer, such as some etched widths of 0.5mm, some etched widths of 0.6mm, some etched widths of 0.3mm, etc. In order to meet the needs of different processes and manufacturers, semiconductor wafer edge processing devices with different etching sizes are manufactured separately, which is costly.

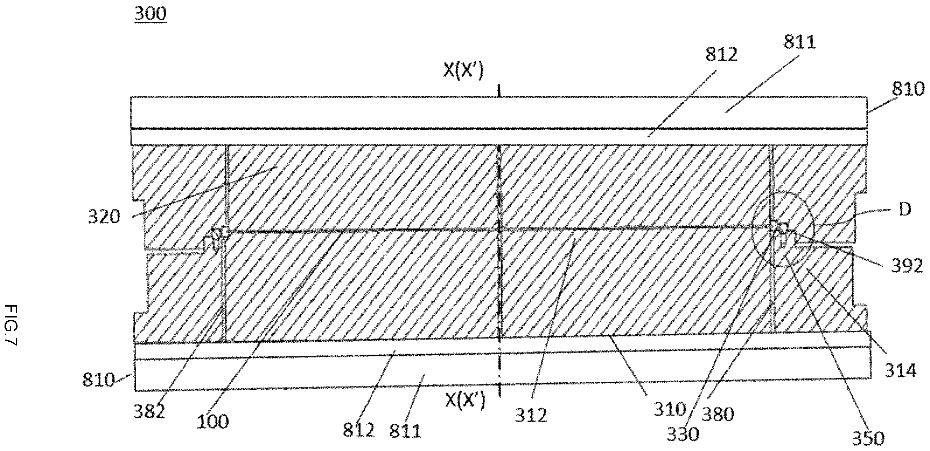

To overcome these issues, the present disclosure provides a semiconductor processing device for fine-tuning an etched width of the edge of a wafer. FIG 7 illustrates an exemplary schematic diagram of the structure of a semiconductor processing device which can fine tune the etched width of the edge of the wafer.

The semiconductor processing device in FIG. 7 is structurally largely identical to the semiconductor processing device in FIG. 3a, except that the semiconductor processing device in FIG.7 also comprises a temperature control component 810 disposed adjacent to the upper chamber and a temperature control component 810 disposed adjacent to the lower chamber. The structure of the two temperature control components can be the same or different. The temperature control component 810 can adjust the temperature of the upper chamber 320 and the temperature of the lower chamber 310 by adjusting its own temperature. By adjusting the temperature of the upper chamber 320 and the lower chamber 310 by utilizing the temperature control component 810, the heat-expansion and cold-contraction of the upper chamber 320 and the lower chamber 310 is utilized to fine-tune a position of the edge of the first supporting area and/or the second supporting area, thereby adjusting the width of the edge of the wafer 100 extending into the first space 332, ultimately adjusting the etched width of the edge of the wafer 100. Specificly, if the expansion of the upper chamber 320 and the lower chamber 310 causes the edge of the first supporting area and/or the second supporting area to expand outward, the width of the edge of the wafer 100 that extends into the first space 332 will decrease, thereby reducing the etched width of the edge of the wafer 100; if the contraction of the upper chamber 320 and the lower chamber 310 causes the edges of the first supporting area and/or the second supporting area to contract inward, the width of the edge of the wafer 100 that extends into the first space 332 will increase, thereby increasing the etching width of the edge of the wafer 100. It should be noted that the expansion and contraction here are relative. Similarly, the temperature control component 810 can also be added to the semiconductor processing devices shown in FIGs. 2a and 4a.

The temperature control component 810 provides for adjusting the temperature of the upper chamber and the lower chamber as required. Adjusting the temperature of the temperature control component 810 can reduce the small changes in the size of the upper and lower chambers caused by environmental temperature changes or other factors, and can also actively adjust the etching width of the edge of the wafer. Thus, the same semiconductor processing device can meet the application of multiple different etched width of the edge of the wafer, without manufacturing multiple semiconductor processing devices for such application. Furthermore, even if the etched width of the edge of the wafer obtained by the semiconductor processing device does not meet the requirements, the etching width of the edge of the wafer obtained can be adjusted by the temperature control component 810.

In one implementation , the temperature control component 810 comprises a temperature adjustment part 811 and a heat diffusion part 812. The heat diffusion part 812 is disposed between the temperature adjustment part 811 and the upper chamber 320. The temperature adjustment part 811 comprises a plurality of electric heating units. The temperature of the temperature adjustment part 811 is controlled by controlling the electric heating units. The heat diffusion part 812 transfers heat to the upper chamber 320, thereby adjusting the temperatures of the upper chamber 320 and the lower chamber. In particular, the electric heating units can be electric resistance heater.

The temperature control component 810 can be detachably designed with the upper chamber 320 and the lower chamber 310, and assembled together through connection components. Alternatively, the temperature control component 810 may be integrally designed with the upper chamber 320 and the lower chamber 310. In other implementations, the temperature control component 810 can also be disposed only on a lower side of the lower chamber 310, or only on an upper side of the upper chamber 320.

By providing the temperature control component 810, the requirements of processing, transportation, and installation of the semiconductor processing device can be greatly reduced. Additionally, it can adjust the etched width of the edge of the wafer, promoting the application of the semiconductor processing device.

The above description is intended to be illustrative, and not restrictive. Although the present disclosure has been described with references to specific illustrative examples, it will be recognized that the present disclosure is not limited to the examples described. The scope of the disclosure should be determined with reference to the following claims, along with the full scope of equivalents to which the claims are entitled.

As used herein, the singular forms "a", "an" and "the" are intended to comprise the plural forms as well, unless the context clearly indicates otherwise. It will be further understood that the terms "comprises", "comprising", "comprises", and/or "including", when used herein, specify the presence of stated features, integers, steps, operations, elements, and/or components, but do not preclude the presence or addition of one or more other features, integers, steps, operations, elements, components, and/or groups thereof. Also, the terms "first," "second," "third," "fourth," etc., as used herein are meant as labels to distinguish among different elements and may not necessarily have an ordinal meaning according to their numerical designation. Therefore, the terminology used herein is for the purpose of describing particular implementations only and is not intended to be limiting.

Many modifications and other implementations of the disclosure set forth herein will come to mind to one skilled in the art to which the disclosure pertains having the benefit of the teachings presented in the foregoing description and the associated figures. Therefore, it is to be understood that the disclosure is not to be limited to the specific implementations disclosed and that modifications and other implementations are intended to be comprised within the scope of the appended claims. Moreover, although the foregoing description and the associated figures describe example implementations in the context of certain example combinations of elements and/or functions, it should be appreciated that different combinations of elements and/or functions may be provided by alternative implementations without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A semiconductor processing device, comprising:
a lower chamber having a first supporting area for supporting a wafer;
an upper chamber having a second supporting area, wherein when the upper chamber is engaged with the lower chamber, the wafer is placed between the first supporting area and the second supporting area;
a temperature control component disposed adjacent to the upper chamber and/or the lower chamber, configured to adjust a temperature of the upper chamber and/or the lower chamber by adjusting its own temperature; and
a first channel formed at an edge area of the first supporting area or the second supporting area, wherein the first channel is configured to provide a first space for flow of one or more chemical fluids for etching an edge of the wafer;
wherein the temperature control component adjusts the temperature of the upper chamber and/or the lower chamber to fine-tune a position of an edge of the first supporting area and/or the second supporting area by utilizing a heat-expansion and cold-contraction of the upper chamber and/or the lower chamber, thereby adjusting a width of the edge of the wafer extending into the first space, ultimately adjusting an etched width of the edge of the wafer.

2. The semiconductor processing device according to claim 1, wherein the upper chamber and/or the lower chamber comprises a positioning structure being configured to press against an outer end of the edge of the wafer and to align a center axis of the wafer with a center axis of the second supporting area.

3. The semiconductor processing device according to claim 2, wherein the upper chamber comprises the positioning structure which is a protrusion part being configured to press against the outer end of the edge of the wafer and to align the center axis of the wafer with the center axis of the second supporting area.

4. The semiconductor processing device according to claim 3, wherein the protrusion part of the upper chamber is adjacent to the second supporting area and extends toward the lower chamber, the center axis of the wafer being perpendicular to an upper surface of the wafer, the center axis of the second supporting area being perpendicular to a lower surface of the upper chamber, and the upper surface of the wafer being parallel to the lower surface of the second supporting area;
wherein the protrusion part comprises a curved part in closed loop arranged around the wafer, and the protrusion part is configured to uniformly press against the outer end of the edge of the wafer for overlapping the center axis of the wafer with the center axis of the second supporting area.

5. The semiconductor processing device according to claim 2, wherein the protrusion part comprises a plurality of juts being circularly and evenly arranged around the wafer to be uniformly press against the outer end of the edge of the wafer.

6. The semiconductor processing device according to claim 3, wherein the protrusion part comprises an inner surface inclining at an angle to the center axis of the second supporting area, the inner surface being configured to press against the outer end of the edge of the wafer;
wherein the protrusion part comprises an inner corner facing towards the center axis of the second supporting area, the inner corner being configured to press against the outer end of the edge of the wafer.

7. The semiconductor processing device according to claim 1, wherein a first groove is formed at a peripheral area of the lower chamber and configured to provide a first groove space for the flow of one or more chemical fluids, and wherein a passage is formed between the upper chamber and the lower chamber, the passage connects the first space with the first groove space, allowing the one or more chemical fluids to flow from the first space to the first groove space through the passage.

8. The semiconductor processing device according to claim 7, wherein a second groove is formed at a peripheral area of the upper chamber and positioned above the first groove;
wherein an elastic component is placed between the first groove and the second groove, the elastic component being configured to block the one or more chemical fluids flowing from the first space to the first groove space;
wherein the first channel is formed at the peripheral area of the second supporting area, and wherein the upper chamber comprises a first through hole configured to allow the one or more chemical fluids to flow between the first space and the outside of the device;
wherein a second channel is formed at the peripheral area of the first supporting area and configured to provide a second space for the flow of the one or more chemical fluids for etching the edge of the wafer;
wherein the lower chamber comprises a second through hole configured to allow the one or more chemical fluids to flow between the second space and the outside of the device;
wherein the first channel is formed at the peripheral area of the first supporting area, and wherein the lower chamber comprises a first through hole configured to allow the one or more chemical fluids to flow between the first space and the outside of the device.

9. The semiconductor processing device according to claim 1, wherein the temperature control component comprises a temperature adjustment part and a heat diffusion part, wherein the heat diffusion part is arranged between the temperature adjustment part and the upper chamber and/or the lower chamber, the temperature adjustment part comprises a plurality of electric heating units.

10. A semiconductor processing system, comprising:
a semiconductor processing device; and
a material storage device connected to the semiconductor processing device for storing and exchanging one or more chemical fluids in the semiconductor processing device;
wherein the semiconductor processing device comprises:
a lower chamber having a first supporting area configured to support a wafer;
an upper chamber having a second supporting area, wherein when the upper chamber is engaged with the lower chamber, the wafer is placed between the first supporting area and the second supporting area;
a temperature control component disposed adjacent to the upper chamber and/or the lower chamber, configured to adjust a temperature of the upper chamber and/or the lower chamber by adjusting its own temperature; and
a first channel formed at an edge area of the first supporting area or the second supporting area, wherein the first channel is configured to provide a first space for the flow of one or more chemical fluids for etching an edge of the wafer;
wherein the temperature control component adjusts the temperature of the upper chamber and/or the lower chamber to fine-tune the position of the edge of the first supporting area and/or the second supporting area by utilizing a heat-expansion and cold-contraction of the upper chamber and/or the lower chamber, thereby adjusting a width of the edge of the wafer extending into the first space, ultimately adjusting an etched width of the edge of the wafer.

11. The semiconductor processing system according to claim 10, wherein the protrusion part is adjacent to the second supporting area and extends toward the lower chamber, the center axis of the wafer being perpendicular to an upper surface of the wafer, the center axis of the second supporting area being perpendicular to a lower surface of the upper chamber, and the upper surface of the wafer being parallel to the lower surface of the second supporting area, the protrusion part comprises a closed loop arranged around the wafer, the protrusion part is configured to uniformly press against the outer end of the edge of the wafer for overlapping a center axis of the protrusion part with the center axis of the second supporting area.

12. The semiconductor processing system according to claim 10, wherein the protrusion part is adjacent to the second supporting area and extends toward the lower chamber, the center axis of the wafer being perpendicular to an upper surface of the wafer, the center axis of the second supporting area being perpendicular to a lower surface of the upper chamber, and the upper surface of the wafer being parallel to the lower surface of the second supporting area; and the protrusion part comprises a plurality of juts being circularly and evenly arranged around the wafer to uniformly press against the outer end of the edge of the wafer.

13. The semiconductor processing system according to claim 10, wherein a first groove is formed at a peripheral area of the lower chamber and configured to provide a first groove space for the flow of one or more chemical fluids; a passage is formed between the upper chamber and the lower chamber, the passage connects the first space with the first groove space, allowing the one or more chemical fluids to flow from the first space to the first groove space through the passage; and a second groove is formed at a peripheral area of the upper chamber and positioned above the first groove, an elastic component being placed between the first groove and the second groove for blocking the one or more chemical fluids flowing from the first space to the first groove space.
